# EUROPEAN PATENT APPLICATION

(11) **EP 2 492 964 A1**
(43) Date of publication of application: **29.08.2012**
(21) Application number: 12154909.1
(22) Date of filing: 10.02.2012
(51) Int. Cl.: H01L 29/861, H01L 29/872

(54) **Semiconductor device and device with use of it**

(30) Priority: 22.02.2011 JP 2011035304
(71) Applicant: Hitachi Ltd., Tokyo (JP)
(72) Inventor: Terakawa, Takeshi, Tokyo, 100-8220 (JP); Matsuyoshi, Satoshi, Tokyo, 100-8220 (JP); Narita, Kazutoyo, Tokyo, 100-8220 (JP); Mori, Mutsuhiro, Tokyo, 100-8220 (JP)
(74) Representative: Beetz & Partner

(57) **Abstract**

There is disclosed a semiconductor device (120) capable of improving reliability, a rotating electrical machine using the semiconductor device (120) or a vehicle using the semiconductor device. The semiconductor device includes Schottky barrier junctions (S) and pn junctions (Z1). The pn junctions are provided in rectification areas and guard ring parts. Breakdown voltage at pn junctions (Z1) in the rectification area is lower than breakdown voltage at the Schottky barrier junctions (S) and the pn junctions in the guard ring parts.

## Description

### BACKGROUND OF THE INVENTION

The present invention relates to a semiconductor device and a device with use of it.

In Schottky barrier diodes (SBD), when surge current flows through Schottky barrier junction of SBD, characteristics of SBD are easily changed, so that it is required that surge current is prevented from flowing through Schottky barrier junction. JP-A-9-9522 and JP-A-3-250670, for example, disclose conventional semiconductor device using SBD.

JP-A-9-9522 and JP-A-3-250670 disclose structure having Schottky barrier junction and pn junction combined to improve allowable maximum surge voltage.

More concretely, in JP-A-9-9522, n⁻-layer is arranged on n⁺-layer and n-type area is formed under guard ring in the n⁻-layer. Metal film or layer is disposed on n⁻-layer and Schottky barrier junction is formed therebetween. JP-A-9-9522 describes operation that surge current does not flow through Schottky barrier junction but flows through guard ring part.

Further, in JP-A-3-250670, n⁻-layer is arranged on n⁺-layer and p-layer is formed in the n⁻-layer. Metal film or layer is disposed on n⁻-layer and Schottky barrier junction is formed therebetween. P-layer disposed in boundary between main electrode and n⁻-layer is arranged between p-layers disposed deeply in n⁻layer.

### SUMMARY OF THE INVENTION

However, according to the structure described in JP-A-9-9522, surge current concentrates in guard ring part. Guard ring part has low heat conduction and accordingly when surge current flows through guard ring part, temperature of device is increased, so that it is apprehended that reliability is reduced.

Moreover, in the structure of JP-A-3-250670, pn junction Z2 is uniformly disposed in rectification area, although since any part has the same breakdown voltage, only part having unstable electric field is broken down. Accordingly, surge current flows through guard ring, so that it is also apprehended that reliability is reduced.

Accordingly, it is an object of the present invention to provide a semiconductor device which can improve reliability and a device with use of it.

In order to solve the above problem, in the semiconductor device according to the present invention including Schottky barrier junction and pn junction, the pn junction is disposed in rectification area and guard ring part and a breakdown voltage of pn junction in rectification area is lower than breakdown voltage of Schottky barrier junction and pn junction in guard ring.

According to the present invention, reliability can be improved. Other objects, features and advantages of the invention will become apparent from the following description of the embodiments of the invention taken in conjunction with the accompanying drawings.

Other objects, features and advantages of the invention will become apparent from the following description of the embodiments of the invention taken in conjunction with the accompanying drawings.

### BRIEF DESCRIPTION OF THE DRAWINGS

Fig. 1 is a sectional view schematically illustrating a semiconductor device according to an embodiment 1;
Figs. 2A to 2H show fabrication processes of the semiconductor device according to the embodiment 1;
Fig. 3 is a sectional view showing flow of carriers upon application of surge voltage in the semiconductor device according to the present invention;
Fig. 4 is a graph showing I-V characteristic of pn junction and SBD;
Figs. 5A and 5B show band structure (Schottky barrier junction) in case where low-concentration P-type diffusion layer is not provided and in case where it is provided, respectively;
Fig. 6 is a sectional view of a semiconductor device according to an embodiment 2;
Fig. 7 is a diagram schematically illustrating an alternator to which the semiconductor device according to the embodiments is applied and which concerns an

### embodiment 3; and

Fig. 8 is a single-line connection diagram showing circuit state according to an embodiment 4.

### DESCRIPTION OF THE EMBODIMENTS

Embodiments preferable to implement the present invention are now described. It is needless to say that the following is mere examples of implementation and does not specify embodiments.

### [EMBODIMENT 1]

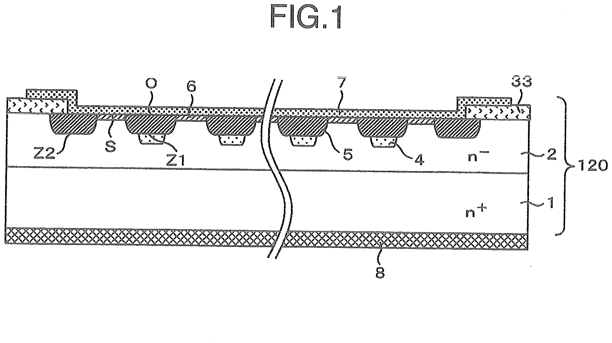

Referring now to Figs. 1 to 4, the embodiment 1 is described. The semiconductor device according to the embodiment includes low-concentration N-type epitaxial layer 2 formed on surface of high-concentration N-type substrate 1 and low-concentration P-type diffusion layer 6 and metal electrode 7 forming Schottky barrier junction described later arranged on low-concentration N-type epitaxial layer 2. Metal electrode 7 is made of MoSi₂, for example, and forms Schottky barrier junction, so that barrier of junction can be lowered and stability can be improved. Metal electrode 7 is not limited to be made of MoSi₂ and can be made of any material as far as the material can form Schottky barrier junction. Outer ends of metal electrode 7 are bent and lifted and insulation layer 33 is disposed between the bent and lifted ends of metal electrode 7 and low-concentration N-type epitaxial layer 2. Rear electrode layer 8 is formed on lower surface of high-concentration N-type substrate 1. Current flows between metal electrode 7 and rear electrode layer 8.

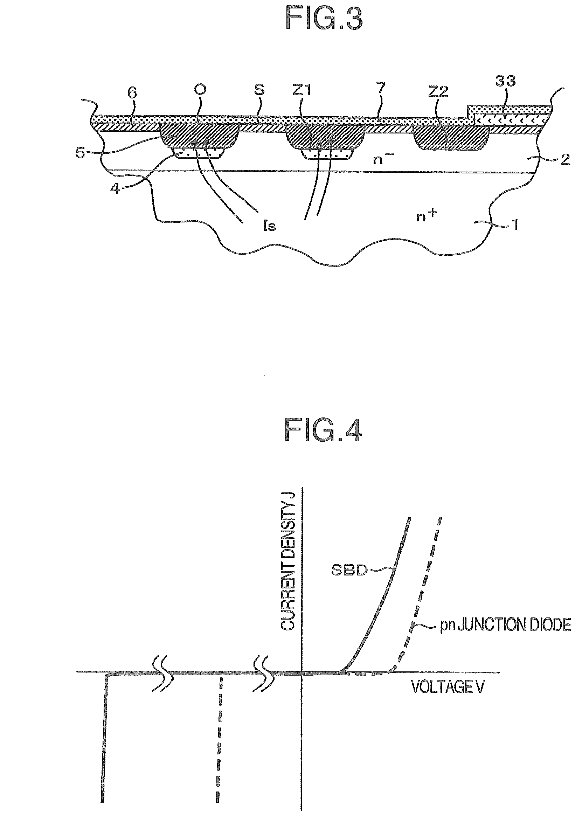

Plural high-concentration P-type diffusion layers 5 are arranged between metal electrode 7 and low-concentration N-type epitaxial layer 2 along junction surface (in right and left direction in Fig. 1) at regular intervals so as to make current flow uniformly to prevent decrease of current overload capacity of device. Outermost parts of high-concentration P-type diffusion layers 5 constitute guard ring parts. Low-concentration P-type diffusion layers 6 having thickness in vertical direction thinner than that of high-concentration P-type diffusion layers 5 are arranged between high-concentration P-type diffusion layers 5. Metal electrode 7 and low-concentration N-type epitaxial layer 2 do not directly come into contact with each other by means of high-concentration P-type diffusion layers 5 and low-concentration P-type diffusion layers 6. High-concentration P-type diffusion layers 5 and N-type diffusion layers 4 form pn junction, whereas since low-concentration P-type diffusion layers 6 and metal electrode 7 form SBD, current easily flows through SBD upon application of forward bias voltage as shown in Fig. 4 and on the other hand surge current easily flows through high-concentration P-type diffusion layers 5 upon application of reverse bias voltage. Higher concentration impurity than low-concentration N-type epitaxial layer 2 is contained in tip center parts of high-concentration P-type diffusion layers 5 on the side of low-concentration N-type epitaxial layer 2 in rectification area (guard ring part is not contained) and N-type diffusion layers 4 constituting lower resistance layer as compared with low-concentration N-type epitaxial layer 2 is disposed in the tip center parts of high-concentration P-type diffusion layers 5.

Metal electrode 7 and low-concentration N-type epitaxial layer 2 form Schottky barrier junction (shown by S in Fig. 1) through low-concentration P-type diffusion layers 6 and ohmic contact (shown by O in Fig. 1) is formed between metal electrode 7 and high-concentration P-type diffusion layers 5. pn junctions are formed between high-concentration P-type diffusion layers 5 and low-concentration N-type epitaxial layer 2 (junction surface is represented by Z2 in Fig. 1) and between high-concentration P-type diffusion layers 5 and N-type diffusion layers 4 (junction surface is represented by Z1 in Fig. 1). In this manner, Schottky barrier junctions and pn junctions are provided together. Breakdown voltage at pn junctions between high-concentration P-type diffusion layers 5 and N-type diffusion layers 4 is lower than breakdown voltage at Schottky barrier junctions and pn junctions between high-concentration P-type diffusion layers 5 and low-concentration N-type epitaxial layer 2, so that breakdown voltages can be arranged in a hierarchical structure manner.

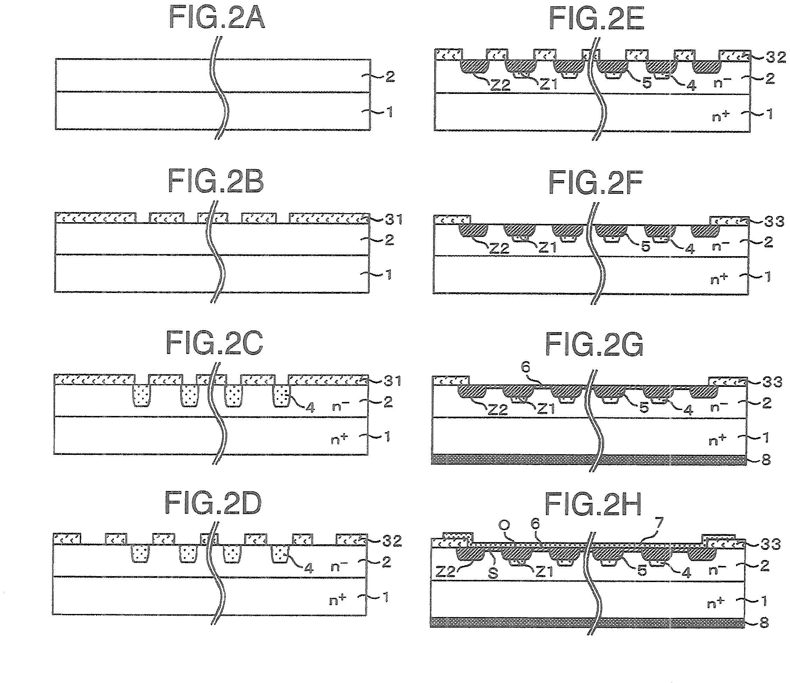

Referring now to Figs. 2A to 2H, manufacturing process of the semiconductor device according to the present invention is described. First of all, as shown in Fig. 2A, low-concentration N-type epitaxial layer 2 is deposited or accumulated on high-concentration N-type substrate 1 by means of epitaxial growth method. Then, as shown in Fig. 2B, insulation layers (silicon oxide (SiO₂) layers) 31 having openings of predetermined area corresponding to formation places of pn junctions Z1 in rectification area excluding guard ring parts are formed on low-concentration N-type epitaxial layer 2. Next, as shown in Fig. 2C, N-type impurity is implanted or injected into low-concentration N-type epitaxial layer 2 through insulation layers (silicon oxide layers) 31 by means of ion implantation method to form N-type diffusion layers 4. After removing insulation layers (silicon oxide layers) 31, as shown in Fig. 2D, insulation layers (silicon oxide layers) 32 having openings of predetermined area corresponding to formation places of guard ring parts (or formation places of pn junctions Z2) and formation places of pn junctions Z1 are formed on low-concentration N-type epitaxial layer 2. At this time, it is preferable that the openings of insulation layers 32 cover the openings formed when N-type diffusion layers 4 are formed and are larger in area than the openings for N-type diffusion layers 4. Next, as shown in Fig. 2E, P-type impurity is injected into low-concentration N-type epitaxial layer 2 through insulation layers (silicon oxide layers) 32 by means of ion implantation method to form high-concentration P-type diffusion layers 5. That is, in this process, pn junctions Z1 are formed between N-type diffusion layers 4 and high-concentration P-type diffusion layers 5 in rectification layer excluding guard ring parts and pn junctions Z2 are formed between low-concentration N-type epitaxial layer 2 and high-concentration P-type diffusion layers 5 in guard ring parts. At this time, the relation between breakdown voltage V_{Z1} of pn junctions Z1 and breakdown voltage V_{Z2} of pn junctions Z2 has the relation of V_{Z1}<V_{Z2} and breakdown voltages can be arranged in a hierarchical structure manner.

Next, as shown in Fig. 2F, after removing insulation layers (silicon oxide layers) 32, insulation layers (silicon oxide layers) 33 being in contact with part of guard ring parts are formed on surface of low-concentration N-type epitaxial layer 2. After insulation layer 33 is formed, as shown in Fig. 2G, P-type impurity is injected into low-concentration N-type epitaxial layer 2 through insulation layers (silicon oxide layers) 33 by means of ion implantation method to form low-concentration P-type diffusion layers 6.

Then, as shown in Fig. 2H, metal electrode 7 made of molybdenum, nickel or titanium is formed on surface of low-concentration N-type epitaxial layer 2. At this time, Schtottky barrier junctions S are formed by low-concentration N-type epitaxial layer 2 and metal electrode 7 and ohmic contacts O are formed by high-concentration P-type diffusion layers 5 and metal electrode 7. Finally, rear electrode layer 8 made of aluminum, gold or silver is formed on opposite side of high-concentration N-type substrate 1 to low-concentration N-type epitaxial layer 2 in ohmic contact manner.

In the above description, N-type diffusion layers 4 and high-concentration P-type diffusion layers 5 are formed by means of ion implantation method, although any method such as solid phase diffusion method, evaporation method, sputtering method and gas diffusion method may be used in addition to ion implantation method as far as the method can dope impurity.

Referring now to Fig. 3, operation of the semiconductor device according to the embodiment at the time of application of reverse surge voltage is described. When high surge voltage is applied to device, current flows from part of device having low breakdown voltage, while in the embodiment N-type diffusion layers 4 having higher impurity concentration than low-concentration N-type epitaxial layer 2 at periphery thereof are arranged on tip of high-concentration P-type diffusion layers in rectification area on the side of low-concentration N-type epitaxial layer 2 and N-type diffusion layers 4 have large concentration gradient and strong electric field as compared with low-concentration N-type epitaxial layer 2 at periphery thereof. Accordingly, breakdown voltage at pn junctions between high-concentration P-type diffusion layers 5 and N-type diffusion layers 4 is lower than breakdown voltage at Schottky barrier junctions (breakdown voltage at pn junctions is lower than that of Schottky barrier junctions as shown in Fig. 4) and pn junctions between high-concentration P-type diffusion layers 5 and low-concentration N-type epitaxial layer 2 and when high surge voltage is applied, breakdown is started from pn junctions having lowest breakdown voltage between high-concentration P-type diffusion layers 5 and N-type diffusion layers 4, so that surge current flows. Fig. 3 schematically illustrates the state of device at the time of application of surge voltage. As shown in Fig. 3, surge current flows through N-type diffusion layers 4 into high-concentration P-type diffusion layers 5. Accordingly, surge current does not flow through Schottky barrier junctions S and pn junctions Z2 in guard ring parts.

According to the embodiment, since Schottky barrier junctions and pn junctions formed in guard ring parts and rectification areas are provided together, reverse surge current does not flow through Schottky barrier junctions having higher breakdown voltage than pn junctions upon application of surge voltage, so that surge current flows through pn junctions. Accordingly, surge current does not flow through Schottky barrier junctions and rectification characteristic is not deteriorated.

Furthermore, in the embodiment, N-type diffusion layers 4 are not disposed in pn junctions Z2 provided in guard ring parts and N-type diffusion layers 4 are provided in pn junctions Z1 provided in rectification areas so that concentration gradient of pn junctions is made larger and electric field applied to pn junctions is made larger, so that breakdown voltage at pn junctions in rectification area among pn junctions is reduced. By reducing breakdown voltage at pn junctions in rectification area as compared with pn junctions in guard ring parts, reverse surge current does not flow through Schottky barrier junctions and in addition thereto reverse surge current does not flow through even guard ring parts. Measures for making concentration gradient of pn junctions larger and making electric field applied to pn junctions larger are not limited to provision of diffusion layers on tip and another alternative measures may be used.

High-concentration P-type diffusion layers 5 in guard ring parts are in partial contact with metal electrode 7 made of metal and the degree of conduction of heat in right and left direction in Fig. 3 within metal electrode having high thermal conductivity is lower as compared with rectification area which high-concentration P-type diffusion layers 5 are in contact with as a whole and heat radiation degree is small. Accordingly, when reverse surge current flows in guard ring parts having low heat radiation, heat is stagnated or accumulated in device and temperature of device rises, so that there arises a problem of decrease of reliability such as decrease of efficiency and life. However, according to the embodiment, breakdown voltage at pn junctions in rectification areas is made lower than pn junctions in guard ring parts and surge current generated upon application of surge voltage does not flow through pn junctions in guard ring parts. Accordingly, temperature rise of device can be avoided and reliability can be improved.

Further, guard ring parts are easy to become higher electrical intensity as compared with rectification areas. When breakdown voltage at such parts is lower as compared with rectification areas or is substantially equal to that of rectification areas, guard ring parts are broken down and surge current flows through guard ring parts, so that temperature of guard ring parts rises. When temperature of guard ring parts having low heat radiation rises, extremely undesirable result occurs in semiconductor device from viewpoint of decrease of reliability. Accordingly, it is important that guard ring parts are prevented from being broken down.

In the embodiment, it is possible that reverse surge current is prevented from flowing in guard ring parts as described above. Accordingly, reliability can be improved.

Moreover, plural pn junctions in rectification areas having lowered breakdown voltage are provided, so that probability that reverse surge current flows into guard ring parts and Schottky barrier junctions can be made lower and concentration of surge current is prevented, so that device itself is difficult to be broken down.

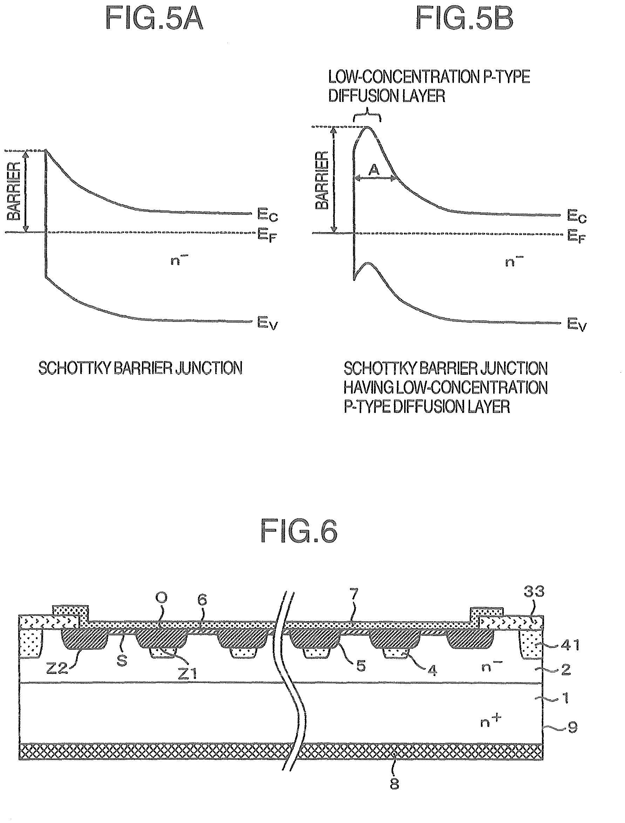

Further, in the embodiment, low-concentration P-type diffusion layers 6 are provided in Schottky barrier junction parts. Band structure of Schottky barrier junction parts including low-concentration P-type diffusion layers 6 is as shown in Fig. 5. Height of barrier to carrier movement in Schottky barrier junctions can be adjusted by low-concentration P-type diffusion layers 6 and peak of barrier can be formed in silicon (in low-concentration P-type diffusion layers 6). By forming peak of barrier in silicon, thickness (area A in Fig. 5) of band can be increased and leakage current due to tunneling current can be prevented from being increased. Further, it is difficult to be influenced by contamination on surface of semiconductor device and accordingly characteristics are stable.

Furthermore, sheet resistance of low-concentration P-type diffusion layers 6 can be set to equal to or larger than 40 kΩ/□ to make ideality factor n converge to 1, so that Schottky barrier junctions having ideal I-V characteristic can be attained. Accordingly, recombination current is also reduced and high efficiency is attained.

### [EMBODIMENT 2]

Referring now to Fig. 6, the embodiment 2 is described. In the embodiment, channel stoppers 41 are provided outside of guard ring parts in addition to the contents described in the embodiment 1. Other structure except that is the same as the embodiment 1 and detailed description thereof is omitted.

Channel stoppers 41 forming N-type diffusion layers having opposite polarity to high-concentration P-type diffusion layers 5 can be provided to thereby suppress depletion layers extending from high-concentration P-type diffusion layers 5. Accordingly, depletion layers can be prevented from reaching silicon side 9 and silicon side 9 can be protected.

Further, channel stoppers 41 forming N-type diffusion layers can be formed through insulation layers (silicon oxide layers) 31 in the same manner as N-type diffusion layers 4 in manufacturing process described in the embodiment 1 and accordingly new process is not increased and manufacturing load is not increased.

### [EMBODIMENT 3]

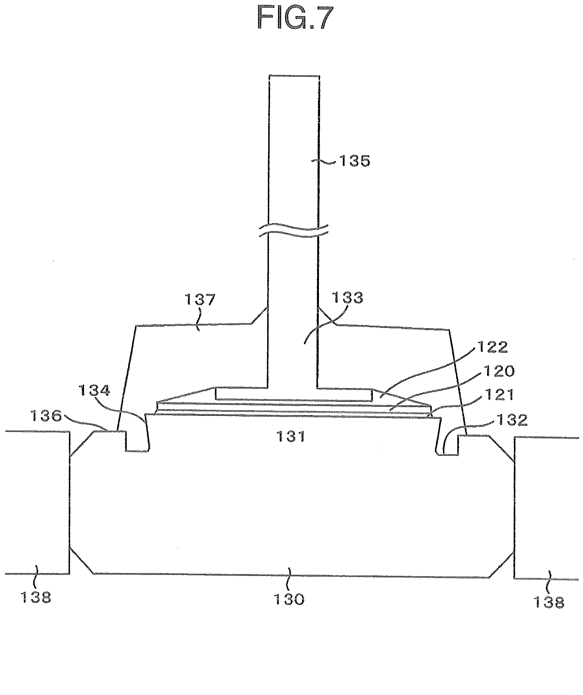

Referring now to Fig. 7, the embodiment 3 is described. In the embodiment, the semiconductor device described in the embodiments is mounted on alternator diode. Semiconductor chip 120 corresponding to the semiconductor device described in the embodiments is electrically connected to supporting electrode body 130 at one end side of semiconductor chip 120 on pedestal 131 in center part of supporting electrode body 130 by means of junction material 121 made of Pb-Sn system or containing no lead. Groove 132 is formed around pedestal 131 and outer peripheral side of groove 132 formed into circle forms outer peripheral side wall 136. Outer peripheral side wall 136 is press-fitted into round hole of heat radiation plate 138 on outer peripheral side. That is, alternator diode is fixed in press-fitted state into heat radiation plate 138, so that heat radiation characteristic can be enhanced. Pedestal 131 makes it possible to mount semiconductor chip 120 on side of lead electrode 135 described later rather than outer peripheral side wall 136 of supporting electrode body 130.

Lead electrode 135 is electrically connected to center part of semiconductor chip 120 on the other end side thereof through junction material 122 made of Pb-Sn system or containing no lead. Solder containing no lead can be used to reduce burden on environment.

As described above, electrode bodies are disposed on both of upper and lower end sides of semiconductor chip 120 and voltage is applied or current flows between electrode bodies through junction material 121 and semiconductor chip 120.

Pedestal 131 of supporting electrode body 130, groove 132, part of outer peripheral side wall 136 and base 133 of lead electrode forming junction between lead electrode 135 and semiconductor chip 120 are sealed by resin 137 so that semiconductor chip 120 and solder part are covered. Provision of groove 132 can firmly fix shaped resin and prevent resin from falling off. Sealing using resin can relieve concentrated stress at the time that supporting electrode body 130 is press-fitted into heat radiation plate 138 and reliability of alternator diode to mechanical stress and thermal stress is enhanced.

As described in the embodiment, the semiconductor device described in the embodiments can be used to increase reliability to temperature rise upon use. Specifically, as the embodiment, when the semiconductor device is used for alternator diode, temperature rises upon use and accordingly improvement of heat-resisting property is large subject. Accordingly, it is advantageous that the semiconductor device which can avoid temperature rise and improve reliability is used. Further, measures for thermal stress even in alternator diode itself is large subject, while the embodiment shown in Fig. 7 can be adopted to spread use temperature range and improve life by fatigue for thermal stress.

Furthermore, groove 132 can be formed to thereby reduce stress concentrated on semiconductor chip when supporting electrode body 130 is press-fitted into heat radiation plate 138 and further groove 132 can be formed to go toward inner peripheral side as groove advances toward inside of pedestal as shown in Fig. 7, so that falling off of resin can be prevented.

### [EMBODIMENT 4]

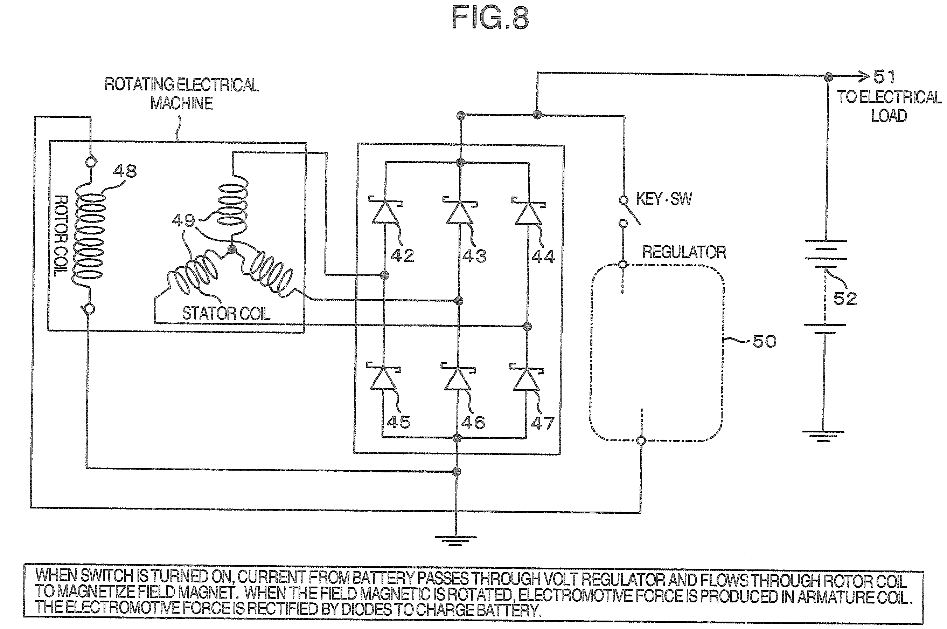

Referring now to Fig. 8, the embodiment 4 is described. A rotating electrical system according to the embodiment includes rotor winding 48 provided in rotor, stator windings 49 provided in stator opposite to rotor with predetermined gap to take out alternating currents of three phases generated, semiconductor device described in the embodiments and operated as diodes 42 to 47 connected to stator windings 49 of three phases, regulator 50 connected to DC side of the semiconductor device, load 51 connected to DC side of the semiconductor device similarly and battery 52 connected to regulator 50 and load 51. Regulator 50 controls current supplied to rotor winding 48 on the basis of voltage value of battery 52. Rotating electrical system in this specification represents system including at least rotating electrical machine having rotor winding and stator windings and diodes connected to stator windings. It is a matter of course that other constituent elements except the above may be added. Further, the rotating electrical machine is described to intend electric generator, although it is possible that another power source is provided and the rotating electrical machine is used to drive load as motor.

Various loads are considered as load 51 and when the rotating electrical machine is mounted in automobile, air-conditioner, car stereo, illuminator in automobile, audio system and the like are contained as load. Specifically, in hybrid car and electric car, the rotating electrical machine can be supposed to be connected to driving motor. The rotating electrical machine is suitable for even general vehicles regardless of automobile.

As described in the embodiments, the semiconductor device can be applied to rotating electrical system and vehicles in which the rotating electrical system is mounted.

It should be further understood by those skilled in the art that although the foregoing description has been made on embodiments of the invention, the invention is not limited thereto and various changes and modifications may be made without departing from the spirit of the invention and the scope of the appended claims.

The above embodiments of the invention as well as the appended claims and figures show multiple characterizing features of the invention in specific combinations. The skilled person will easily be able to consider further combinations or sub-combinations of these features in order to adapt the invention as defined in the claims to his specific needs.

## Claims

1. A semiconductor device including Schottky barrier junctions and pn junctions, wherein
the pn junctions are formed in rectification areas and guard ring parts and breakdown voltage of the pn junctions in the rectification areas is lower than breakdown voltage of the Schottky barrier junctions and the pn junctions in the guard ring parts.

2. A semiconductor device according to Claim 1, wherein
the pn junctions in the rectification areas include first diffusion layers (5) having p or n conductivity type and layers (4) having conductivity type opposite to the p or n conductivity type of the first diffusion layers (5), the first diffusion layers (5) being joined with the opposite conductivity type layers (4) to form the pn junctions between the first diffusion layers (5) and the opposite conductivity type layers (4), and
a second diffusion layer (2) having the same conductivity type as the opposite conductivity type layers (4) and having higher impurity concentration than the opposite conductivity type layers (4) is formed on junction planes of the pn junctions in the rectification areas on side of the opposite conductivity type layers (4).

3. A semiconductor device according to Claim 1, wherein
plural pn junctions in the rectification areas are provided.

4. A semiconductor device according to Claim 1, wherein
pn junctions are further formed in junction planes constituting the Schottky barrier junctions on side of semiconductor.

5. A semiconductor device according to Claim 1, wherein
channel stoppers (41) are disposed outside of the guard rings.

6. A semiconductor device according to Claim 1, wherein
sheet resistance of junction planes constituting the Schottky barrier junctions on side of semiconductor is equal to or larger than 40k Ω /□.

7. A semiconductor device according to Claim 1, wherein
electrode (7) constituting the Schottky barrier junctions is made of MoSi₂.

8. An alternator diode including the semiconductor device according to Claim 1 and electrodes (130,135) provided at both ends of the semiconductor device, wherein
the semiconductor device is connected to the electrodes by solder and
the semiconductor device and the solder are sealed by resin (137).

9. An alternator diode according to Claim 8, further comprises a support (130) to support the semiconductor device and the resin (137) and
a groove (132) formed in the support (130) to hold the resin (137).

10. A rotating electrical system comprising a rotating electrical machine including rotor and stator disposed opposite to the rotor with predetermined gap, and diodes (42, 43, 44, 45, 46, 47) connected to stator windings (49) provided in the stator and including the semiconductor device according to any one of Claims 1 to 7 to convert alternating current into direct current.

11. A rotating electrical system according to Claim 10, wherein
the rotor includes rotor winding (48) and the rotor winding (48) includes a regulator (50) to control voltage applied to the rotor winding (48) and
the regulator (50) is electrically connected to direct current side of the diodes (42 ,43, 44, 45, 46, 47).

12. A vehicle comprising the rotating electrical system according to Claim 10 and load electrically connected to the rotating electrical system.
